# EUROPÄISCHE PATENTSCHRIFT

(11) **EP 1 501 909 B1**
(45) Veröffentlichungstag und Bekanntmachung des Hinweises auf die Patenterteilung: **27.02.2008**
(21) Anmeldenummer: 03735284.6
(22) Anmeldetag: 06.05.2003
(51) Int. Cl.: C09K 11/02, H01L 33/00

(54) **WELLENLÄNGENKONVERTIERENDE REAKTIONSHARZMASSE UND LEUCHTDIODENBAUELEMENT**
WAVELENGTH-CONVERTING REACTIVE RESINOUS COMPOUND AND LIGHT-EMITTING DIODE COMPONENT
MATIERE DE RESINE A CONVERSION DE LONGUEURS D'ONDES ET COMPOSANT DIODE ELECTROLUMINESCENTE

(30) Priorität: 06.05.2002 DE 10220137
(43) Veröffentlichungstag der Anmeldung: 02.02.2005
(73) Patentinhaber: Osram Opto Semiconductors GmbH, 93049 Regensburg (DE)
(72) Erfinder: BRAUNE, Bert, 93173 Wenzenbach (DE); RUHNAU, Marcus, 92557 Weiding (DE)
(74) Vertreter: Epping - Hermann - Fischer
(86) Internationale Anmeldenummer: PCT/DE2003/001452
(87) Internationale Veröffentlichungsnummer: WO 2003/093393

(56) Entgegenhaltungen:
- EP-A- 1 024 185
- WO-A-01/51585
- US-A1- 2001 048 966

## Beschreibung

Die Erfindung betrifft eine wellenlängenkonvertierende Reaktionsharzmasse nach dem Oberbegriff des Patentanspruches 1, ein Verfahren zu deren Herstellung und ein Leuchtdiodenbauelement mit einer solchen Reaktionsharzmasse.

Eine wellenlängenkonvertierende Reaktionsharzmasse der eingangs genannten Art ist aus der WO 98/12757 bekannt. Hierin ist eine wellenlängenkonvertierende Reaktionsharzmasse beschrieben, bei der in ein transparentes Gießharz ein anorganisches Leuchtstoffpigmentpulver mit Korngrößen ≤ 20 µm und einem mittleren Korndurchmesser d₅₀ ≤ 5 µm dispergiert ist.

Auf dem Gebiet der Leuchtdioden (LEDs) ermöglicht der Einsatz von Konversionsleuchtstoffen die Erzeugung von mischfarbigem Licht mittels eines einzigen LED-Chips. Hierbei erfolgt eine Absorption zumindest eines Teiles der von einem LED-Chip emittierten Strahlung durch den Konversionsleuchtstoff, der dann wiederum Strahlung anderer Wellenlänge als die absorbierte emittiert. Diese vom Leuchtstoff emittierte und eine vom LED-Chip emittierte und nicht vom Leuchtsoff absorbierte Strahlung ergeben dann zusammen die mischfarbige Strahlung.

In bekannten Leuchtdiodenbauelementen, die mit Reaktionsharzmassen der eingangs genannten Art gefertigt sind, werden Leuchtstoffmaterialien mit einer Dichte zwischen 4 und 5 g/cm³ eingesetzt. Die verwendeten Leuchstoffpulver weisen Leuchtoffpartikel auf, deren mittlere Partikeldurchmesser in der Regel unter 5 µm liegen.

Beim Einsatz von größeren Leuchtstoffpartikeln, sedimentieren diese in den herkömmlich verfügbaren Reaktionsharzsystemen wie beispielsweise Epoxidharz, während des Herstellungsprozesses.

Insbesondere während der Aufheizphase eines Harzes kurz vor dem Beginn des Aushärteprozesses sinkt deren Viskosität soweit ab, daß Leuchtstoffpartikel nicht mehr in der Schwebe gehalten werden und aussedimentieren.

Diese Sedimentation läßt sich, wie in der WO 98/12757 vorgeschlagen, durch die Zugabe von Aerosil zum Gießharz für Leuchtstoffpartikel mit einem mittleren Korndurchmesser d₅₀ ≤ 5 µm so weit einschränken, dass nach dem Aushärteprozess des Gießharzes eine sehr gute Verteilung der Leuchtstoffpartikel im Gießharz erzielt werden kann.

Mit dieser Methode der Thixotropierung mittels Aerosil ließen sich auch Leuchtstoffe mit größeren Partikeln einsetzen, wenn größere Mengen an Aerosil beigemischt würden. Da aber die Zugabe von herkömmlichem Aerosil die Transparenz der Harzmasse verringert, ist die Zugabemenge für solches Aerosil bei den herkömmlichen Bauformen derart begrenzt, dass beispielsweise bei YAG:Ce-Leuchtstoff die Grenze des mittleren Partikeldurchmessers bei etwa 5 µm liegt.

In der EP 1 024 185 A2 ist ein anorganisches Bindemittel für Leuchtstoffbeschichtungen offenbart. Das Bindemittel weist Nanopartikel auf, die mit dem Leuchtstoff in der Beschichtung dispergiert sind. Es wird zudem die Verwendung von SiO₂-Partikeln anstatt Aluminiumoxid-Partikeln vorgeschlagen, die angeblich bei einer Vakuum UV-Strahlung als Primärstrahlung zu einer erhöhten Effizienz fluoreszierender Lampen führen können, ohne die Klebkraft der Leuchtstoffbeschichtung zu beeinträchtigen.

Der Erfindung liegt die Aufgabe zugrunde, eine Thixotropierung von Reaktionsharzmassen zu entwickeln, mit der die Sedimentation von Leuchtstoffpartikeln mit einem mittleren Partikeldurchmesser von größer als 5 µm, bevorzugt von größer als 5µm und kleiner als oder gleich 20 µm weitestgehend verhindert werden kann und gleichzeitig eine ausreichende Transparenz der Reaktionsharzmasse erhalten bleibt.

Diese Aufgabe wird durch eine Reaktionsharzmasse mit den Merkmalen des Patentanspruches 1 gelöst. Bevorzugte Weiterbildungen der Erfindung sind Gegenstand der Ansprüche 2 bis 24.

Bei der erfindungsgemäßen wellenlängenkonvertierenden Reaktionsharzmasse liegt zumindest ein Teil des Thixotropiermittels in Form von Nanopartikeln vor. Solche Nanopartikel sind vorzugsweise Partikel mit einem mittleren Partikeldurchmesser zwischen 1 nm und 100 nm.

Damit können vorteilhafterweise anorganische Leuchtstoffpartikel mit einem mittleren Partikeldurchmesser größer als 5 µm in dem Reaktionsharz dispergiert werden, ohne dass durch die Thixotropierung die Transparenz der Reaktionsharzmasse in unakzeptabler Weise beeinträchtigt ist.

Die anorganischen Leuchtstoffpartikel können vorteilhafterweise einen d₅₀-Wert, in Q3 gemessen, aufweisen, der zwischen einschließlich 10 µm und einschließlich 20 µm ist.

Bevorzugt enthält das Thixotropiermittel Nanopartikel mit einem in Q3 gemessenen d₅₀-Wert zwischen einschließlich 1 nm und einschließlich 25 nm. Besonders bevorzugt liegt der d₅₀-Wert zwischen einschließlich 5 nm und einschließlich 15 nm, insbesondere zwischen einschließlich 9 nm und einschließlich 12 nm.

Die Reaktionsharzmasse weist vorzugsweise mindestens ein Material aus der Gruppe bestehend aus Epoxidharz, Silikonharz und Acrylharz auf. Dies sind vorteilhafterweise die in der Optoelektronik herkömmlich verwendeten Reaktionsharzmaterialien beispielsweise für LED-Chips. Alternativ können andere optisch transparente Reaktionsharzmassen, beispielsweise Heteropolymere wie zum Beispiel Cellulosederivate, Polycarbonate, Polysulfone, Polyimide, Polyamide etc., Polyolefine (z. B. Polyethylen), Styrol-Polymerisate, Polyurethane etc. eingesetzt werden.

Das Thixotropiermittel enthält vorzugsweise ein kolloidales SiO₂-Sol. Als Thixotropiermittel sind auch folgende Materialien einsetzbar: Titandioxid, Zirkonoxid oder SiO₂. Besonders geeignet sind hierbei pyrogen hergestellte Oxide, die auch ein dem Reaktionsharz angepasstes Oberflächencoating aufweisen. Beispiele sind diesbezüglich oberflächenbehandelte Aerosile (SiO₂), beispielsweise solche der Firma Degussa, welche von ihren Eigenschaften her dem kolloidalen SiO₂ entsprechen. Beschichtete Aerosil-Pulver haben den Vorteil, dass sie bei ähnlich thixotroper Wirkung wie das kolloidale SiO₂-Sol dem Reaktionsharz als Pulver zugegeben werden können, wohingegen bei einer Reaktionsharz/Sol-Mischung vorzugsweise vor dem Härten das Lösungsmittel entzogen werden sollte. Andere Nanopartikel, hergestellt in einem kolloidchemischen Prozess, durch progenen Prozess in einer Gasphasenreaktion erzeugt oder in einem Sol-Gel-Verfahren erzeugt, sind ebenfalls denkbar. Grundsätzlich sind für die Nanopartikel alle Herstellungsverfahren geeignet, die nanometergroße Partikel erzeugen können.

Die Reaktionsharzmasse eignet sich besonders bevorzugt zum Umhüllen eines strahlungsemittierenden Körpers, insbesondere eines Halbleiterchips, dessen Emissionsstrahlungsspektrum zumindest Strahlung aus dem ultravioletten, blauen oder grünen Spektralbereich enthält. Hierbei ist sie vorteilhafterweise zumindest für einen Teil der vom Körper emittierten Strahlung durchlässig ist und der Leuchtstoff enthält vorzugsweise zumindest Leuchtstoffpartikel aus der Gruppe der mit seltenen Erden dotierten Granate, mit seltenen Erden dotierten Thiogallate, mit seltenen Erden dotierten Aluminate oder mit seltenen Erden dotierten Orthosilikate.

Besonders bevorzugt enthält der Leuchtstoff Leuchtstoffpartikel aus der Gruppe der Granate mit der allgemeinen Formel A₃B₅O₁₂:M, wobei die Komponente A mindestens ein Element aus der Gruppe bestehend aus Y, Gd, Tb, La, Lu, Sc und Sm umfaßt, die Komponente B mindestens ein Element aus der Gruppe bestehend aus Al, Ga und In umfaßt und die Komponente M mindestens ein Element aus der Gruppe bestehend aus Ce, Pr, Eu, Cr, Nd und Er umfaßt. Für weißes Licht emittierende Leuchtdiodenbauelemente mit einem blaues Licht emittierenden Leuchtdiodenchip, dessen Emissionsspektrum vorzugsweise bei einer Wellenlänge zwischen einschließlich 420 nm und einschließlich 475 nm ein Intensitätsmaximum aufweist, eignet sich als Leuchtstoff besonders bevorzugt ein Y₃Al₅O₁₂ :Ce- und/oder (Y, Gd, Tb)₃(Al,Ga)₅O₁₂:Ce-Leuchtstoff.

weitere geeignete Leuchtstoffgruppen sind die Nitridosilikate und die Oxynitride, aber auch die mit Seltenen Erden dotierten Thiogallate wie z. B. CaGa₂S₄:Ce³⁺ und SrGa₂S₄:Ce³⁺, die mit Seltenen Erden dotierten Aluminate wie z. B. YAlO₃:Ce³⁺, YGaO₃:Ce ³⁺ Y(Al,Ga)O₃:Ce³⁺ und die mit Seltenen Erden dotierten Orthosilikate wie Y₂SiO₅:Ce³⁺. Diese und andere geeignete Leuchtstoffe sind beispielsweise in den Druckschriften WO/98/12757, WO 01/08452 und WO 01/08453 beschrieben.

Nanopartikel erlauben eine wesentlich stärkere Thixotropierung des Reaktionsharzes ohne gleichzeitig die Transparenz unakzeptabel zu verringern als dies bei herkömmlicher Zugabe eines herkömmlichen Aerosils möglich ist.

Durch den Einsatz von Nanopartikel es möglich, Reaktionsharze unter Beibehaltung einer vertretbaren Transparenz soweit zu thixotropieren, daß Partikel eines Leuchtstoffs wie YAG-Cer mit einer mittleren Partikelgröße von 10 - 20 µm im Wesentlichen ohne Sedimentation bei der Herstellung einer LED eingesetzt werden können.

Sich daraus ergebende Vorteile sind einerseits weniger aufwendige und damit kostengünstigere Mahlverfahren der Leuchtstoffe. Andererseits sinkt der Bedarf an Leuchtstoff, da die Effizienz eines Leuchtstoffs im unteren µm-Bereich mit steigender Partikelgröße wächst.

Bei Einsatz von Nanopartikeln mit höherer Brechzahl, wie z.B. TiO₂ oder ZrO₂, kann auch die Gesamtbrechzahl der Reaktionsharzmasse erhöht werden, was eine verbesserte Lichtauskopplung aus einem Leuchtdiodenbauelement bewirkt.

Überdies kann vorteilhaferweise zum Beispiel durch Zugabe von Nanopartikeln aus TiO₂ oder ZrO₂ eine Schutzwirkung gegen blaues Licht mit Wellenlängen unterhalb 410 nm erreicht werden.

Bei einer besonders bevorzugten Weiterbildung der erfindungsgemäßen Reaktionsharzmasse weist diese Epoxidharz auf und enthält diese bezogen auf die A-Komponente des Epoxidharzes zwischen 1 Gew% und 15 Gew% Leuchtstoff und vorzugsweise kolloidale SiO₂-Nanopartikel in einer Konzentration zwischen 5 Gew% und 30 Gew%. Der mittlere Durchmesser der Leuchtstoffpartikel liegt hierbei vorzugsweise oberhalb 5 µm und und unterhalb 20 µm und besonders bevorzugt zwischen 10 µm und 20 µm. Weiterhin kann ein mineralischem Diffusor, Verarbeitungshilfsmittel, Hydrophobiermittel und/oder Haftvermittler zugesetzt werden.

Geeignete Epoxidharze sind beispielsweise in der DE-OS 26 42 465 auf den Seiten 4 bis 9, insbesondere Beispiele 1 bis 4, und in der EP 0 039 017 auf den Seiten 2 bis 5, insbesondere Beispiele 1 bis 8, beschrieben.

Als mineralischer Diffusor zur Optimierung des Leuchtbildes des Bauelements kann CaF₂ verwendet sein.

Als verarbeitungshilfsmittel eignet sich beispielsweise Glykolether. Es verbessert die Verträglichkeit zwischen Epoxidharz und Leuchtpigmentpulver und dient damit zur Stabilisierung der Dispersion Leuchtpigmentpulver - Epoxidharz. Zu diesem Zweck können auch Oberflächenmodifikatoren auf Silikonbasis eingesetzt werden.

Das Hydrophobiermittel, z. B. flüssiges Silikonwachs, dient ebenfalls zur Modifikation der Pigmentoberfläche, insbesondere wird die Verträglichkeit und Benetzbarkeit der anorganischen Pigmentoberfläche mit dem organischen Harz verbessert.

Der Haftvermittler, z. B. funktionelles Alkoxysiloxan, verbessert die Haftung zwischen den Pigmenten und dem Epoxidharz im ausgehärteten Zustand der Reaktionsharzmasse. Dadurch wird erreicht, daß die Grenzfläche zwischen dem Epoxidharz und den Pigmenten z. B. bei Temperaturschwankungen nicht abreißt. Spalte zwischen dem Epoxidharz und den Pigmenten würden zu Lichtverlusten im Bauelement führen.

Das Epoxidharz, bevorzugt mit einem reaktiven Oxirandreiring, enthält vorzugsweise ein mono- und/oder ein mehrfunktionelles Epoxidharzsystem (≥ 80 Gew%; z. B. Bisphenol-A-Diglycidylether), einen Reaktivverdünner (≤ 10 Gew%; z. B. aromatischer Monoglycidylether), einen mehrfunktionellen Alkohol (≤ 5 Gew%), ein Entgasungsagens auf Silikonbasis (≤ 1 Gew%) und eine Entfärbungskomponente zur Einstellung der Farbzahl (≤ 1 Gew%) .

Desweiteren weist das bevorzugt hochreine Leuchtstoffpulver vorteilhafterweise einen Eisengehalt von ≤ 5ppm auf. Ein hoher Eisengehalt führt zu hohen Lichtverlusten im Bauelement. Das Leutstoffpulver ist stark abrasiv. Der Fe-Gehalt der Reaktionsharzmasse kann bei deren Herstellung daher beträchtlich ansteigen. Vorteilhaft sind Fe-Gehalte in der Reaktionsharzmasse < 20 ppm .

Der anorganische Leuchtstoff YAG:Ce hat unter anderem den besonderen Vorteil, daß es sich hierbei um nicht lösliche Farbpigmente mit einem Brechungsindex von ca. 1,84 handelt. Dadurch treten neben der Wellenlängenkonversion Dispersion und Streueffekte auf, die zu einer guten Vermischung von blauer Diodenstrahlung und gelber Konverterstrahlung führen.

Zur weiteren Verminderung der Agglomeratbildung können die Leuchtstoffpartikel vorteilhafterweise mit einem Silikon-Coating versehen sein.

Bei einem bevorzugten Verfahren zum Herstellen einer erfindungsgemäßen Reaktionsharzmasse wird das Leuchtstoffpulver vor dem Vermischen mit dem Reaktionsharz z. B. ca. 10 Stunden bei einer Temperatur ≥ 200°C getempert. Dadurch kann ebenfalls die Neigung zu Agglomeratbildung verringert werden.

Alternativ oder zusätzlich kann dazu das Leuchtstoffpulver vor dem Vermischen mit dem Reaktionsharz in einem höher siedenden Alkohol geschlämmt und anschließend getrocknet wird. Eine weitere Möglichkeit die Agglomeratbildung zu verringern besteht darin, dem Leuchtstoffpulver vor dem Vermischen mit dem Reaktionsharz ein hydrophobierendes Silikonwachs zuzugeben. Besonders vorteilhaft ist die Oberflächenstabilisierung der Phosphore durch erwärmen der Pigmente in Gegenwart von Glykolethern, z. B. 16 h bei T > 60°C.

Zur Vermeidung störender Verunreinigungen beim Dispergieren der Leuchstoffpartikel, verursacht durch Abrieb, werden Reaktionsgefäße, Rühr- und Dispergiervorrichtungen sowie Walzwerke aus Glas, Korund, Carbid- und Nitridwerkstoffen sowie speziell gehärtete Stahlsorten verwendet. Agglomeratfreie Leuchtstoffdispersionen werden auch in Ultraschallverfahren oder durch den Einsatz von Sieben und Glaskeramikfritten erhalten.

Zur Erzeugung von mischfarbigem Licht eignen sich neben den bereits oben genannten speziellen Leuchtsoffmaterialien besonders die mit Seltenen Erden dotierten Thiogallate wie z. B. Ca-Ga₂S₄ : Ce³⁺ und SrGa₂S₄ : Ce³⁺. Ebenso ist hierzu die Verwendung von mit Seltenen Erden dotierten Aluminaten wie z. B. YAlO₃:Ce³⁺, YGaO₃ : Ce³⁺, Y (Al, Ga) O₃ : Ce³⁺ und mit Seltenen Erden dotierten Orthosilikaten M₂SiO₅:Ce³⁺ (M: Sc, Y, La) wie z. B. Y₂SiO₅ : Ce³⁺ denkbar. Bei allen Yttriumverbindungen kann das Yttrium im Prinzip auch durch Scandium oder Lanthan ersetzt werden.

Bevorzugt wird die erfindungsgemäße Reaktionsharzmasse bei einem strahlungsemittierenden Halbleiterkörper, insbesondere mit einer aktiven Halbleiterschicht oder -schichtenfolge aus GaN, GaₓIn₁₋ₓN, GaₓAl₁-ₓN und/oder AlₓGa_{y}In_{1-x-y}N eingesetzt, der im Betrieb eine elektromagnetische Strahlung aus dem ultravioletten, blauen und/oder grünen Spektralbereich aussendet.

Die Leuchtstoffpartikel in der Reaktionsharzmasse wandeln einen Teil der aus diesem Spektralbereich stammenden Strahlung in Die Leuchtstoffpartikel in der Reaktionsharzmasse wandeln einen Teil der aus diesem Spektralbereich stammenden Strahlung in Strahlung mit größerer Wellenlänge um, derart, daß das Halbleiterbauelement Mischstrahlung, insbesondere mischfarbiges Licht, bestehend aus dieser Strahlung und aus Strahlung aus dem ultravioletten, blauen und/oder grünen Spektralbereich aussendet.

Das heißt beispielsweise, daß die Leuchtstoffpartikel einen Teil der vom Halbleiterkörper ausgesandten Strahlung spektral selektiv absorbieren und im längerwelligen Bereich emittieren. Bevorzugt weist die von dem Halbleiterkörper ausgesandte Strahlung bei einer Wellenlänge λ≤ 520 nm, bevorzugt zwischen 420 nm und 475 nm, ein relatives Intensitätsmaximum auf und liegt der von den Leuchtstoffpartikeln spektral selektiv absorbierte Wellenlängenbereich außerhalb dieses Intensitätsmaximums.

Ebenso können vorteilhafterweise auch mehrere verschiedenartige Leuchtstoffpartikelarten, die bei unterschiedlichen Wellenlängen absorbieren und/oder emittieren, in der Reaktionsharzmasse dispergiert sein. Dies wird bevorzugt druch unterschiedliche Dotierungen in unterschiedlichen Wirtsgittern erreicht. Dadurch ist es vorteilhafterweise möglich, vielfältige Farbmischungen und Farbtemperaturen des vom Bauelement emittierten Lichtes zu erzeugen. Von besonderem Interesse ist dies für vollfarbtaugliche LEDs.

Bei einer bevorzugten Verwendung der erfindungsgemäßen Reaktionsharzmasse ist ein strahlungsemittierender Halbleiterkörper (z. B. ein LED-Chip) zumindest teilweise von dieser umschlossen. Die Reaktionsharzmasse ist dabei bevorzugt gleichzeitig als Bauteilumhüllung (Gehäuse) genutzt. Der Vorteil eines Halbleiterbauelements gemäß dieser Ausführungsform besteht im wesentlichen darin, daß zu seiner Herstellung konventionelle, für die Herstellung von herkömmlichen Leuchtdioden (z. B. Radial-Leuchdioden) eingesetzte Produktionslinien verwendet werden können. Für die Bauteilumhüllung wird anstelle des bei herkömmlichen Leuchtdioden dafür verwendeten transparenten Kunststoffes einfach die Reaktionsharzmasse verwendet.

Mit der erfindungsgemäßen Reaktionsharzmasse kann auf einfache Weise mit einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um z. B. mit einem blaues Licht aussendenden Halbleiterkörper weißes Licht zu erzeugen, wird ein Teil der von dem Halbleiterkörper ausgesandten Strahlung mittels anorganischer Leuchtstoffpartikel aus dem blauen Spektralbereich in den zu Blau komplementärfarbigen gelben Spektralbereich konvertiert. Die Farbtemperatur oder Farbort des weißen Lichtes kann dabei durch geeignete Wahl des Leuchtstoffes, dessen Partikelgröße und dessen Konzentration, variiert werden. Darüber hinaus können auch Leuchtstoffmischungen eingesetzt werden, wodurch sich vorteilhafterweise der gewünschte Farbton des abgestrahlten Lichtes sehr genau einstellen läßt.

Besonders bevorzugt wird die Reaktionsharzmasse bei einem strahlungsemittierenden Halbleiterkörper verwendet, bei dem das ausgesandte Strahlungsspektrum bei einer Wellenlänge zwischen 420nm und 460 nm, insbesondere bei ca. 430 - 440 nm (z. B. Halbleiterkörper auf der Basis von GaₓAl₁₋ₓN) oder bei ca. 450 - 475 nm (z. B. Halbleiterkörper auf der Basis von GaₓIn₁₋ₓN) ein Intensitätsmaximum aufweist. Mit einem derartigen Halbleiterbauelement lassen sich vorteilhafterweise nahezu sämtliche Farben und Mischfarben der C.I.E.-Farbtafel erzeugen. An Stelle des strahlungsemittierenden Halbleiterkörpers aus elektrolumineszierendem Halbleitermaterial kann aber auch ein anderes elektrolumineszierendes Material, wie beispielsweise Polymermaterial, eingesetzt werden.

Besonders geeignet ist die Reaktionsharzmasse für ein lichtemittierendes Halbleiterbauelement (z. B. eine Leuchtdiode), bei dem der elektrolumineszierende Halbleiterkörper in einer Ausnehmung eines vorgefertigten eventuell bereits mit einem Leadframe versehenen Gehäuses angeordnet ist und die Ausnehmung mit der Reaktionsharzmasse versehen ist. Ein derartiges Halbleiterbauelement läßt sich in großer Stückzahl in herkömmlichen Produktionslinien herstellen. Hierzu muß lediglich nach der Montage des Halbleiterkörpers in das Gehäuse die Reaktionsharzmasse in die Ausnehmung gefüllt werden.

Ein weißes Licht abstrahlendes Halbleiterbauelement läßt sich mit der erfindungsgemäßen Reaktionsharzmasse vorteilhafterweise dadurch herstellen, daß der Leuchtstoff so gewählt wird, daß eine von dem Halbleiterkörper ausgesandte blaue Strahlung in komplementäre Wellenlängenbereiche, insbesondere Blau und Gelb, oder zu additiven Farbtripeln, z. B. Blau, Grün und Rot umgewandelt wird. Hierbei wird das gelbe bzw. das grüne und rote Licht über die Leuchtstoffe erzeugt. Der Farbton (Farbort in der CIE-Farbtafel) des dadurch erzeugten weißen Lichts kann dabei durch geeignete Wahl des/der Leuchtstoffes/e hinsichtlich Mischung und Konzentration variiert werden.

Um die Durchmischung der von einem elektrolumineszierenden Halbleiterkörper ausgesandten Strahlung mit der vom Leuchtstoff konvertierten Strahlung und damit die Farbriomogenität des vom Bauelement abgestrahlten Lichtes zu verbessern, ist bei einer vorteilhaften Ausgestaltung der erfindungsgemäßen Reaktionsharzmasse zusätzlich ein im Blauen lumineszierender Farbstoff zugefügt, der eine sogenannte Richtcharakteristik der von dem Halbleiterkörper ausgesandten Strahlung abschwächt. Unter Richtcharakteristik ist zu verstehen, daß die von dem Halbleiterkörper ausgesandte Strahlung eine bevorzugte Abstrahlrichtung aufweist.

Ein weißes Licht abstrahlendes erfindungsgemäßes Halbleiterbauelement mit einem blaues Licht emittierenden elektrolumineszierenden Halbleiterkörper läßt sich besonders bevorzugt dadurch realisieren, daß dem für die Reaktionsharzmasse verwendeten Epoxidharz der anorganische Leuchtstoff YAG : Ce (Y₃Al₅O₁₂ : Ce³⁺) beigemischt ist. Ein Teil einer von dem Halbleiterkörper ausgesandten blauen Strahlung wird von dem anorganischen Leuchtstoff Y₃Al₅O₁₂ : Ce³⁺ in den gelben Spektralbereich und somit in einen zur Farbe Blau komplementärfarbigen Wellenlängenbereich verschoben.

Der Reaktionsharzmasse können zusätzlich lichtstreuende Partikel, sogenannte Diffusoren zugesetzt sein. Hierdurch läßt sich vorteilhafterweise der Farbeindruck und die Abstrahlcharakteristik des Halbleiterbauelements weiter optimieren.

Mit der erfindungsgemäßen Reaktionsharzmasse kann vorteilhafterweise auch eine von einem elektrolumineszierenden Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Die Wellenlängenkonversion der Primärstrahlung wird durch die Kristallfeldaufspaltung der aktiven Übergangsmetallzentren im Wirtsgitter bestimmt. Durch die Substitution von Y durch Gd und/oder Lu bzw. Al durch Ga im Y₃Al₅O₁₂-Granatgitter können die Emissionswellenlängen in unterschiedlicher Weise verschoben werden, wie außerdem durch die Art der Dotierung. Durch die Substitution von Ce³⁺-Zentren durch Eu³⁺ und/oder Cr³⁺ können entsprechende Shifts erzeugt werden. Entsprechende Dotierungen mit Nd³⁺ und Er³⁺ ermöglichen sogar aufgrund der größeren Ionenradien und damit geringeren Kristallfeldaufspaltungen IRemittierende Bauelemente.

Weitere Merkmale, Vorteile und Zweckmäßigkeiten der Erfindung ergeben sich aus den im Folgenden in Verbindung mit den Figuren 1 bis 6 beschriebenen Ausführungsbeispielen. Es zeigen:
Figur 1 eine schematische Schnittansicht eines ersten Halbleiterbauelements mit einer erfindungsgemäßen Reaktionsharzmasse;
Figur 2 eine schematische Schnittansicht eines zweiten Halbleiterbauelements mit einer erfindungsgemäßen Reaktionsharzmasse;
Figur 3 eine schematische Schnittansicht eines dritten Halbleiterbauelements mit einer erfindungsgemäßen Reaktionsharzmasse;
Figur 4 eine schematische Schnittansicht eines vierten Halbleiterbauelements mit einer erfindungsgemäßen Reaktionsharzmasse;
Figur 5 eine schematische Schnittansicht eines fünften Halbleiterbauelements mit einer erfindungsgemäßen Reaktionsharzmasse; und
Figur 6 eine schematische Schnittansicht eines sechsten Halbleiterbauelements mit einer erfindungsgemäßen Reaktionsharzmasse.

In den verschiedenen Figuren sind gleiche bzw. gleichwirkende Teile immer mit denselben Bezugszeichen bezeichnet.

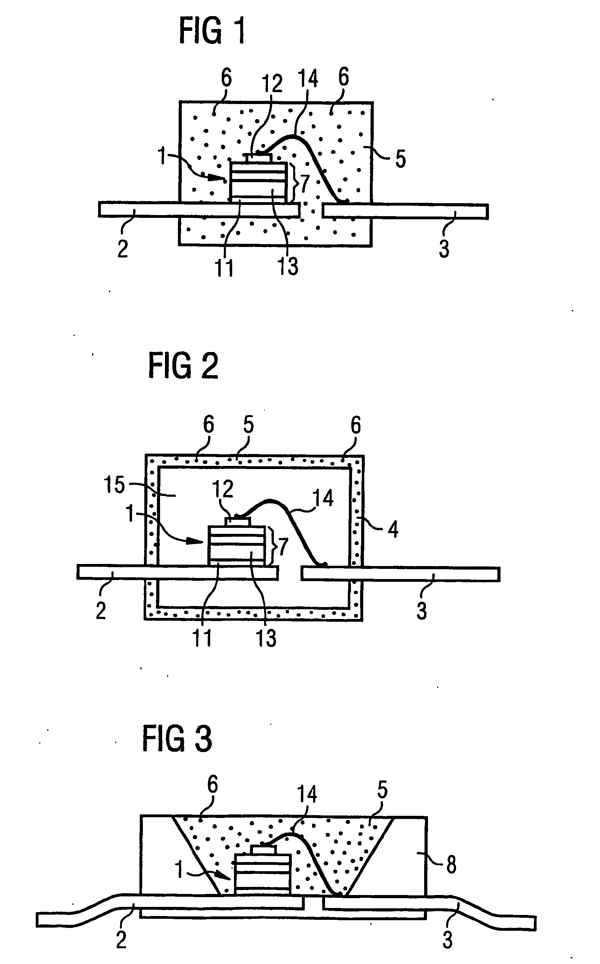

Das lichtemittierenden Halbleiterbauelement von Figur 1 weist eine erfindungsgemäße Reaktionsharzmasse auf. Der Halbleiterkörper 1, ein LED-Chip 7 mit einer aktiven Schicht oder Schichtenfolge (zum Beispiels Multi-Quantenwell-Struktur) mit einer bzw. einer Mehrzahl von Schichten auf der Basis von InₓGa_{y}Al₁₋ₓ yN (wobei 0≤x≤1, 0≤y≤1 und x+y≤1) ist hierbei mittels eines elektrisch leitenden Verbindungsmittels, z. B. ein metallisches Lot, insbesondere Weichlot, oder ein Klebstoff, mit seinem Rückseitenkontakt 11 auf einem ersten elektrischen Anschluß 2 eines Leiterrahmens (Leadframe) befestigt. Der Vorderseitenkontakt 12 ist mittels eines Bonddrahtes 14 mit einem zweiten elektrischen Anschluß 3 des Leiterrahmens verbunden.

Die freien Oberflächen des Halbleiterkörpers 1 und Teilbereiche der elektrischen Anschlüsse 2 und 3 sind unmittelbar von einer gehärteten, wellenlängenkonvertierenden Reaktionsharzmasse 5 umschlossen. Diese weist bevorzugt auf: Epoxidharz, Leuchtstoffpulver aus Ce-dotiertem Granatmaterial (zum Beispiel YAG:Ce) mit einer Konzentration zwischen einschließlich 1 Gew% und einschließlich 15 Gew%, kolloidale Si02-Nanopartikel mit einer Partikelgröße von 9 bis 12 nm mit einer Konzentration zwischen 5 Gew% und 30 Gew%. Zusätzlich kann noch Diethylenglycolmonomethylether ≤ 2 Gew% und Tegopren 6875-45 ≤ 2 Gew% zugesetzt sein. Die Gew%-Angaben sind auf die A-Komponente des Epoxidharzes bezogen. Das Leuchtstoffpulver enthält beispielsweise Leuchtstoffpartikel 6 mit einem mittleren Durchmesser zwischen 10 µm und 20 µm.

Das in Figur 2 dargestellte Ausführungsbeispiel eines erfindungsgemäßen Halbleiterbauelements unterscheidet sich von dem der Figur 1 dadurch, daß der Halbleiterkörper 1 und Teilbereiche der elektrischen Anschlüsse 2 und 3 anstatt von einer wellenlängenkonvertierenden Reaktionsharzmasse von einer transparenten oder transluzenten Umhüllung 15 umschlossen sind. Diese Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikon- oder Acrylatharz oder aus einem anderen geeigneten strahlungsdurchlässigen Material wie z. B. anorganisches Glas.

Auf diese Umhüllung 15 ist eine Schicht 4 aufgebracht, die aus einer wellenlängenkonvertierenden Reaktionsharzmasse, wie in der Figur 2 dargestellt, die gesamte Oberfläche der Umhüllung 15 bedeckt. Ebenso denkbar ist, daß die Schicht 4 nur einen Teilbereich dieser Oberfläche bedeckt. Die Schicht 4 besteht beispielsweise aus einer Rekationsharzmasse, die auf einem transparenten Epoxidharz basiert und die mit Leuchtstoffpartikeln 6 versetzt ist. Als Reaktionsharzmasse eignet sich hier beispielsweise die im Zusammenhang mit dem ersten Ausführungsbeispiel beschriebene. Auch hier eignet sich als Leuchtstoff für ein weiß leuchtendes Halbleiterbauelement bevorzugt YAG:Ce oder YAG: Ce-bäsierte Leuchtstoffe.

Bei dem in Figur 3 dargestellten besonders bevorzugten mit der erfindungsgemäßen Reaktionsharzmasse versehenen Bauelement, sind der erste und zweite elektrische Anschluß 2,3 eines Leadframes in ein vorzugsweise aus reflektierendem Kunststoff vorgefertigtes Grundgehäuse 8 mit einer Ausnehmung 9 eingebettet. Unter "vorgefertigt" ist zu verstehen, daß das Grundgehäuse 8 bereits an den Anschlüssen 2,3 beispielsweise mittels Spritzgießen oder Spritzpressen fertig ausgebildet ist, bevor der Halbleiterkörper 1 auf den Anschluß 2 montiert wird. Das Grundgehäuse 8 besteht beispielsweise aus einem mit weißem, reflektierendem Füllstoff gefüllter Kunststoff und die Ausnehmung 9 ist hinsichtlich ihrer Form als Reflektor 17 für die vom Halbleiterkörper im Betrieb ausgesandte Strahlung (ggf. durch geeignete Beschichtung der Innenwände der Ausnehmung 9) ausgebildet. Solche Grundgehäuse 8 werden insbesondere bei auf Leiterplatten oberflächenmontierbaren Leuchtdiodenbauelemeten verwendet. Sie werden vor der Montage der Halbleiterkörper auf ein die elektrischen Anschlüsse 2,3 aufweisendes Leiterband (Leadframe) z. B. mittels Spritzgießen aufgebracht.

Die Ausnehmung 9 ist mit einer Reaktionsharzmasse 5 zumindest teilweise gefüllt. Als Reaktionsharzmasse eignet sich hier beispielsweise die im Zusammenhang mit dem ersten Ausführungsbeispiel beschriebene.

Alternativ kann die Ausnehmung mit transparenter oder transluzenter Masse gefüllt sein, die keine oder einer erste Wellenlängenkonversion übernimmt und auf der eine wellenlängenkonvertierende Schicht entsprechend der Schicht 4 von Figur 3 aufgebracht ist.

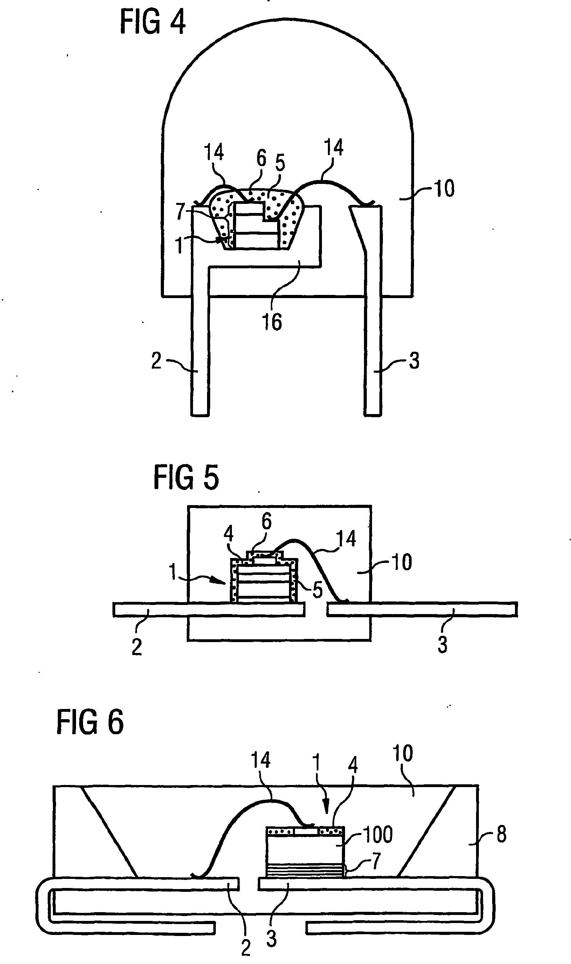

In Figur 4 ist eine sogenannte Radialdiode dargestellt. Hierbei ist der strahlungsemittierende Halbleiterkörper 1 in einem als Reflektor ausgebildeten Teil 16 des ersten elektrischen Anschlußes 2 beispielsweise mittels Löten oder Kleben befestigt. Derartige Gehäusebauformen sind in der Leuchtdiodentechnik bekannt und bedürfen von daher keiner näheren Erläuterung.

Die freien Oberflächen des Halbleiterkörpers 1 sind unmittelbar von einer Reaktionsharzmasse 5 mit Leuchtstoffpartikel 6 bedeckt, die wiederum von einer weiteren transparenten Umhüllung 10 umgeben ist. Als Reaktionsharzmasse eignet sich hier beispielsweise wieder die im Zusammenhang mit dem ersten Ausführungsbeispiel beschriebene.

Der Vollständikeit halber sei an dieser Stelle angemerkt, daß selbstverständlich auch bei der Bauform nach Figur 4 analog zu dem Bauelement gemäß Figur 1 eine einstückige Umhüllung, bestehend aus gehärteter Reaktionsharzmasse 5 mit Leuchtstoffpartikel 6, verwendet sein kann.

Bei dem Ausführungsbeispiel von Figur 5 ist eine Schicht 4 aus einer erfindungsgemäßen Reaktionsharzmasse direkt auf den Halbleiterkörper 1 aufgebracht. Dieser und Teilbereiche der elektrischen Anschlüsse 2,3 sind von einer weiteren transparenten Umhüllung 10 umschlossen, die keine Wellenlängen-änderung der durch die Schicht 4 hindurchgetretenen Strahlung bewirkt und beispielsweise aus einem in der Leuchtdiodentechnik verwendbaren transparenten Epoxidharz oder aus Glas gefertigt ist. Als Reaktionsharzmasse eignet sich hier wiederum beispielsweise die im Zusammenhang mit dem ersten Ausführungsbeispiel beschriebene.

Solche, mit einer Konversionsschicht 4 versehenen Halbleiterkörper 1 können vorgefertigt werden und wahlweise in sämtliche aus der Leuchtdiodentechnik bekannten Gehäusebauformen (z. B. SMD-Gehäuse, Radial-Gehäuse (man vergleiche Figur 4) eingebaut werden. Die Konversionsschicht 4 muß nicht zwangsweise die gesamte freie Oberfläche des Halbleiterkörpers 1 bedecken, sondern sie kann auch nur Teilbereiche des Halbleiterkörpers überspannen. Die Konversionsschicht 4 kann beispielsweise bereits im Waferverbund vor dem endgültigen Vereinzeln des Wafers zu einer Vielzahl von Halbleiterkörpern auf diese aufgebracht werden. Die Konversionsschicht 4 weist weiterhin vorzugsweise eine konstante Dicke auf.

Bei dem in Figur 6 beschriebenen Ausführungsbeispiel ist innerhalb eines Gehäuse-Grundkörpers 8 ein umgedrehter (d.h. Flip-Chip-montierter) LED-Chip 1 auf dem Leadframe 2,3 befestigt.

Dieser weist ein für die von der aktiven Schichtenfolge 7 ausgesandte Strahlung durchlässiges Substrat 100 auf, das zur besseren Strahlungsauskopplung strukturiert sein kann (nicht gezeigt). Auf der von der aktiven Schichtenfolge 7 abgewandten Seite des Substrats ist eine Konversionsschicht 4 aus einer erfindungsgemäßen Reaktionsharzmasse aufgebracht, die durchweg im Wesentlichen die gleiche Dicke aufweist. Die kann, anders als in der Figur dargestellt, auch über die Seitenflächen (Flanken) gezogen sein. Diese Konversionsschicht ist vorzugsweise vor der Montage des LED-Chips auf diesem aufgebracht worden. Nach Montage des Chips in der Ausnehmung des Gehäusegrundktörpers wird dieser vorzugsweise mit einer weiteren Kunststoffmasse umhüllt.

Bei sämtlichen der oben beschriebenen Bauelemente kann zur Optimierung des Farbeindrucks des abgestrahlten Lichts sowie zur Anpassung der Abstrahlcharakteristik die Reaktionsharzmasse 5, ggf. die transparente oder transluzente Umhüllung 15, und/oder ggf. die weitere transparente oder transluzente Umhüllung 10 lichtstreuende Partikel, vorteilhafterweise sogenannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise Reaktionsharzen, wie Epoxidharzen, zugesetzt werden.

Der LED-Chip kann bei allen oben beschriebenen Bauelementen ein blaues Licht abstrahlender LED-Chip sein, dessen Emissionsspektrum unterhalb einer Wellenlänge von 520 nm, bevorzugt zwischen 440 nm und 475 nm zumindest ein lokales Intensitätsmaximum aufweist. Der Leuchtstoff 6 (z. B. YAG:Ce) wandelt einen Teil der Strahlung des LED-Chips in gelbes Licht um, so dass das Bauelement insgesamt weißes Licht aussendet.

Von der vom Halbeiterkörper ausgesandten Strahlung wird nur ein Teil in einen längerwelligen Wellenlängenbereich konvertiert, so daß als Mischfarbe weißes Licht entsteht. Alternativ können zwei Leuchtstoffe verwendet sein, von denen einer rotes Licht Bei den Halbleiterbauelementen gemäß der Erfindung können auf einfache Weise durch Wahl der Leuchtstoffe und/oder Veränderung der Leuchtstoffkonzentration(en) in der Reaktionsharzmasse der CIE-Farbort des Mischlichtes verändert werden.

Bei einem Verfahren zum Herstellen der Reaktionsharzmasse wird zunächst das Thixotropiermittel (die Nanopartikel) dem Reaktionsharz zugesetzt und werden nachfolgend die Leuchtstoffpartikel eingemischt.

Weil größere Leuchtstoffpartikel eine höhere Effizienz aufweisen, lässt sich bei Verwendung größerer Leuchtstoffpartikel im Vergleich zur Verwendung kleinerer Leuchtstoffpartikel die Leuchtstoffkonzentration in der Reaktionsharzmasse bei gleicher Performance (wie gleicher Farbort) verringern.

Die Erläuterung der Erfindung anhand der oben beschriebenen Bauelemente ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein enstprechendes Strahlungsspektrum aussendet.

## Patentansprüche

1. Wellenlängenkonvertierende Reaktionsharzmasse (5), die mit einem wellenlängenkonvertierenden Leuchtstoff (6) und einem Thixotropiermittel versetzt ist, wobei der Leuchtstoff anorganische Leuchtstoffpartikel enthält,
**dadurch gekennzeichnet, daß** zumindest ein Teil des Thixotropiermittels in Form von Nanopartikeln vorliegt.

2. Reaktionsharzmasse nach Anspruch 1,
**dadurch gekennzeichnet daß** die anorganischen Leuchtstoffpartikel einen d₅₀-Wert, in Q3 gemessen, aufweisen, der größer als 5 µm und kleiner als oder gleich 25 µm ist.

3. Reaktionsharzmasse nach Anspruch 1,
**dadurch gekennzeichnet, daß** die anorganischen Leuchtstoffpartikel einen d₅₀-Wert, in Q3 gemessen, aufweisen, der größer als oder gleich 10 µm und kleiner als oder gleich 20 µm ist.

4. Reaktionsharzmasse nach mindestens einem der Ansprüche 1 bis 3,
**dadurch gekennzeichnet, daß** die Nanopartikel des Thixotropiermittels einen d₅₀-Wert, in Q3 gemessen, aufweisen, der größer oder gleich 1 nm und kleiner oder gleich 25 nm ist.

5. Reaktionsharzmasse nach mindestens einem der Ansprüche 1 bis 3,
**dadurch gekennzeichnet, daß** die Nanopartikel des Thixotropiermittels einen d₅₀-Wert, in Q3 gemessen, aufweisen, der größer als oder gleich 5 nm und kleiner als oder gleich 15 nm ist.

6. Reaktionsharzmasse nach mindestens einem der Ansprüche 1 bis 3,
**dadurch gekennzeichnet, daß** die Nanopartikel des Thixotropiermittels einen d₅₀-Wert, in Q3 gemessen, aufweisen, der größer als oder gleich 9 nm und kleiner als oder gleich 12 nm ist.

7. Reaktionsharzmasse nach mindestens einem der Ansprüche 1 bis 6,
**dadurch gekennzeichnet, daß** sie mindestens ein Material aus der Gruppe bestehend aus Epoxidharz, Silikonharz und Acrylharz aufweist.

8. Reaktionsharzmasse nach mindestens einem der Ansprüche 1 bis 7,
**dadurch gekennzeichnet, daß**
das Thixotropiermittel ein kolloidales SiO₂-Sol aufweist.

9. Reaktionsharzmasse nach mindestens einem der Ansprüche 1 bis 8 zum Umhüllen eines strahlungsemittierenden Körpers, insbesondere eines Halbleiterchips, dessen Emissionsstrahlungsspektrum zumindest Strahlung aus dem ultravioletten, blauen oder grünen Spektralbereich enthält, die zumindest für einen Teil der vom Körper emittierten Strahlung durchlässig ist,
**dadurch gekennzeichnet, daß**
der Leuchtstoff zumindest Leuchtstoffpartikel (6) aus der Gruppe der mit seltenen Erden dotierten Granate, mit seltenen Erden dotierten Thiogallate, mit seltenen Erden dotierten Aluminate oder mit seltenen Erden dotierten Orthosilikate enthält.

10. Reaktionsharzmasse nach mindestens einem der Ansprüche 1 bis 8 zum Umhüllen eines strahlungsemittierenden Körpers, insbesondere eines Halbleiterchips, dessen Emissionsstrahlungsspektrum zumindest Strahlung aus dem ultravioletten, blauen oder grünen Spektralbereich enthält, die zumindest für einen Teil der vom Körper emittierten Strahlung durchlässig ist,
**dadurch gekennzeichnet, daß**
der Leuchtstoff zumindest Leuchtstoffpartikel (6) aus der Gruppe der Granate mit der allgemeinen Formel A₃B₅O₁₂:M aufweist,
wobei die Komponente A mindestens ein Element aus der Gruppe bestehend aus Y, Gd, Tb, La, Lu, Sc und Sm enthält, die Komponente B mindestens ein Element aus der Gruppe bestehend aus Al, Ga und In enthält und die Komponente M mindestens ein Element aus der Gruppe bestehend aus Ce, Pr, Eu, Cr, Nd und Er enthält.

11. Reaktionsharzmasse nach einem der Ansprüche 1 bis 10,
**dadurch gekennzeichnet, dass**
das Thixotropiermittel mindestens ein Material der Gruppe bestehend aus kolloidales SiO₂-Sol, Titandioxid, Zirkonoxid und SiO₂ aufweist.

12. Reaktionsharzmasse nach einem der Ansprüche 1 bis 11,
**dadurch gekennzeichnet, dass**
das Thixotropiermittel mindestens ein pyrogen hergestelltes Oxid aufweist.

13. Reaktionsharzmasse nach einem der Ansprüche 1 bis 12,
**dadurch gekennzeichnet, dass**
das Thixotropiermittel Nanopartikel aufweist, die in einem kolloidchemischen Prozess, in einem pyrogenen Prozess in einer Gasphasenreaktion oder in einem Sol-Gel-Verfahren erzeugt sind.

14. Reaktionsharzmasse nach einem der Ansprüche 1 bis 13,
**dadurch gekennzeichnet, dass**
die Nanopartikel zumindest teilweise ein dem Reaktionsharz angepasstes Oberflächencoating aufweisen.

15. Verfahren zur Herstellung einer Reaktionsharzmasse nach mindestens einem der vorgenannten Ansprüche, **dadurch** g e - kennzeichnet, daß einem Reaktionsharz, insbesondere einer A-Komponente eines Epoxidharzes, das Thixotropiermittel zugesetzt wird und nachfolgend Leuchtstoffpartikel eingemischt werden.

16. Verfahren nach Anspruch 15, **dadurch gekennzeichnet, dass** die Leuchtstoffpartikel bei einer Temperatur ≥ 200°C getempert werden.

17. Verfahren nach Anspruch 15 oder 16, **dadurch** g e - kennzeichnet, dass die Leuchtstoffpartikel (6) mit einem Silikon-Coating versehen werden.

18. Verfahren nach einem der Ansprüch 15 bis 17, **dadurch** g e kennzeichnet , daß den Leuchtstoffpartikeln hydrophobierendes Silikonwachs zugegeben wird.

19. Verfahren nach einem der Ansprüche 15 bis 18,
**dadurch gekennzeichnet, dass**
die Nanopartikel in einem kolloidchemischen Prozess, einer Gasphasenreaktion eines pyrogenen Prozesses oder in einem Sol-Gel-Verfahren erzeugt werden.

20. Verfahren nach einem der Ansprüche 15 bis 19,
**dadurch gekennzeichnet, dass** die Nanopartikel oberflächenbehandelt werden.

21. Lichtabstrahlendes optisches Bauelement mit einer wellenlängenkonvertierenden Reaktionsharzmasse nach einem der Ansprüche 1 bis 14 mit einem Halbleiterkörper (1), der im Betrieb des optischen Bauelements elektromagnetische Strahlung aussendet,
**dadurch gekennzeichnet,**
**daß** der Halbleiterkörper (1) eine Halbleiterschichtenfolge (7) aufweist, die geeignet ist, im Betrieb des Halbleiterbauelements elektromagnetische Strahlung aus dem ultravioletten, blauen und/oder grünen Spektralbereich auszusenden,
**daß** die Leuchtstoffpigmente einen Teil der aus diesem Spektralbereich stammenden Strahlung in Strahlung mit größerer Wellenlänge umwandelt, derart, daß das Halbleiterbauelement Mischstrahlung, insbesondere mischfarbiges Licht, bestehend aus der Strahlung mit größerer Wellenlänge und aus Strahlung aus dem ultravioletten, blauen und/oder grünen Spektralbereich aussendet.

22. Lichtabstrahlendes optisches Bauelement nach Anspruch 21,
**dadurch gekennzeichnet, daß** die Reaktionsharzmasse zumindest einen Teil des Halbleiterkörpers (1) umschließt.

23. Lichtabstrahlendes Halbleiterbauelement nach einem der Ansprüche 21 und 22, **dadurch gekennzeichnet, daß** der Halbleiterkörper (1) in einer Ausnehmung (9) eines lichtundurchlässigen Grundgehäuses (8) angeordnet ist und daß die Ausnehmung (9) zumindest teilweise mit der Reaktionsharzmasse (5) gefüllt ist.

24. Lichtabstrahlender Halbleiterkörper mit einer wellenlängenkonvertierenden Reaktionsharzmasse nach einem der Ansprüche 1 bis 14, **dadurch gekennzeichnet, daß** er zumindest auf einem Teil seiner Oberfläche eine Konversionsschicht aus der Reaktionsharzmasse aufweist, die im Wesentlichen durchweg die gleiche Dicke aufweist.

## Claims

1. Wavelength-converting reaction resin composition (5) with which a wavelength-converting luminescent material (6) and a thixotropic agent are admixed, the luminescent material containing inorganic luminescent material particles,
**characterized in that** at least part of the thixotropic agent is present in the form of nanoparticles.

2. Reaction resin composition according to Claim 1,
**characterized in that** the inorganic luminescent material particles have a d₅₀ value, measured in Q3, which is greater than 5 µm and less than or equal to 25 µm.

3. Reaction resin composition according to Claim 1,
**characterized in that** the inorganic luminescent material particles have a d₅₀ value, measured in Q3, which is greater than or equal to 10 µm and less than or equal to 20 µm.

4. Reaction resin composition according to at least one of Claims 1 to 3,
**characterized in that** the nanoparticles of the thixotropic agent have a d₅₀ value, measured in Q3, which is greater than or equal to 1 nm and less than or equal to 25 nm.

5. Reaction resin composition according to at least one of Claims 1 to 3,
**characterized in that** the nanoparticles of the thixotropic agent have a d₅₀ value, measured in Q3, which is greater than or equal to 5 nm and less than or equal to 15 nm.

6. Reaction resin composition according to at least one of Claims 1 to 3,
**characterized in that** the nanoparticles of the thixotropic agent have a d₅₀ value, measured in Q3, which is greater than or equal to 9 nm and less than or equal to 12 nm.

7. Reaction resin composition according to at least one of Claims 1 to 6,
**characterized in that** it has at least one material from the group consisting of epoxy resin, silicone resin and acrylic resin.

8. Reaction resin composition according to at least one of Claims 1 to 7,
**characterized in that**
the thixotropic agent has a colloidal SiO₂ sol.

9. Reaction resin composition according to at least one of Claims 1 to 8 for encapsulating a radiation-emitting body, in particular a semiconductor chip, the emission radiation spectrum of which contains at least radiation from the ultraviolet, blue or green spectral range which is transmissive at least to part of the radiation emitted by the body,
**characterized in that**
the luminescent material contains at least luminescent material particles (6) from the group of garnets doped with rare earths, thiogallates doped with rare earths, aluminates doped with rare earths, or orthosilicates doped with rare earths.

10. Reaction resin composition according to at least one of Claims 1 to 8 for encapsulating a radiation-emitting body, in particular a semiconductor chip, the emission radiation spectrum of which contains at least radiation from the ultraviolet, blue or green spectral range which is transmissive at least to part of the radiation emitted by the body,
**characterized in that**
the luminescent material contains at least luminescent material particles (6) from the group of garnets having the general formula A₃B₅O₁₂ : M, where the component A contains at least one element from the group consisting of Y, Gd, Tb, La, Lu, Sc and Sm, the component B contains at least one element from the group consisting of Al, Ga and In, and the component M contains at least one element from the group consisting of Ce, Pr, Eu, Cr, Nd and Er.

11. Reaction resin composition according to one of Claims 1 to 10,
**characterized in that**
the thixotropic agent has at least one material from the group consisting of colloidal SiO₂ sol, titanium dioxide, zirconium oxide and SiO₂.

12. Reaction resin composition according to one of Claims 1 to 11,
**characterized in that** the thixotropic agent has at least one pyrogenically produced oxide.

13. Reaction resin composition according to one of Claims 1 to 12,
**characterized in that**
the thixotropic agent has nanoparticles produced in a colloid-chemical process, in a pyrogenic process in a gas phase reaction or in a sol-gel method.

14. Reaction resin composition according to one of Claims 1 to 13,
**characterized in that**
the nanoparticles at least partly have a surface coating adapted to the reaction resin.

15. Method for producing a reaction resin composition according to at least one of the preceding claims,
**characterized in that** the thixotropic agent is added to a reaction resin, in particular to an A component of an epoxy resin, and luminescent material particles are subsequently mixed in.

16. Method according to Claim 15, **characterized in that** the luminescent material particles are heat-treated at a temperature of ≥ 200°C.

17. Method according to Claim 15 or 16, **characterized in that** the luminescent material particles (6) are provided with a silicone coating.

18. Method according to one of Claims 15 to 17,
**characterized in that** hydrophobizing silicone wax is added to the luminescent material particles.

19. Method according to one of Claims 15 to 18,
**characterized in that**
the nanoparticles are produced in a colloid-chemical process, a gas phase reaction of a pyrogenic process or in a sol-gel method.

20. Method according to one of Claims 15 to 19,
**characterized in that**
the nanoparticles are surface-treated.

21. Light-emitting optical component comprising a wavelength-converting reaction resin composition according to one of Claims 1 to 14 comprising a semiconductor body (1), which emits electromagnetic radiation during the operation of the optical component, **characterized**
**in that** the semiconductor body (1) has a semiconductor layer sequence (7) suitable for emitting electromagnetic radiation from the ultraviolet, blue and/or green spectral range during the operation of the semiconductor component,
**in that** the luminescent material pigments convert part of the radiation originating from said spectral range into radiation having a longer wavelength, in such a way that the semiconductor component emits mixed radiation, in particular mixed-colour light, comprising the radiation having a longer wavelength and radiation from the ultraviolet, blue and/or green spectral range.

22. Light-emitting optical component according to Claim 21,
**characterized in that** the reaction resin composition encloses at least one part of the semiconductor body (1).

23. Light-emitting semiconductor component according to one of Claims 21 and 22, **characterized in that** the semiconductor body (1) is arranged in a cutout (9) of a light-opaque basic housing (8), and **in that** the cutout (9) is at least partly filled with the reaction resin composition (5).

24. Light-emitting semiconductor body comprising a wavelength-converting reaction resin composition according to one of Claims 1 to 14, **characterized in that** it has, at least on part of its surface, a conversion layer composed of the reaction resin composition which has the same thickness essentially throughout.

## Revendications

1. Matière de résine réactive (5) convertissant les longueurs d'onde, mélangée avec une matière luminescente (6) convertissant les longueurs d'onde et un agent de thixotropie, la matière luminescente contenant des particules minérales de matière luminescente,
**caractérisée en ce qu'**au moins une partie de l'agent de thixotropie est présente sous forme de nanoparticules.

2. Matière de résine réactive selon la revendication 1,
**caractérisée en ce que** les particules minérales de matière luminescente présentent une valeur d₅₀, mesurée dans Q3, qui est supérieure à 5 µm et inférieure ou égale à 25 µm.

3. Matière de résine réactive selon la revendication 1,
**caractérisée en ce que** les particules minérales de matière luminescente présentent une valeur d₅₀, mesurée dans Q3, qui est supérieure ou égale à 10 µm et inférieure ou égale à 20 µm.

4. Matière de résine réactive selon au moins l'une quelconque des revendications 1 à 3,
**caractérisée en ce que** les nanoparticules de l'agent de thixotropie présentent une valeur d₅₀, mesurée dans Q3, qui est supérieure ou égale à 1 nm et inférieure ou égale à 25 nm.

5. Matière de résine réactive selon au moins l'une quelconque des revendications 1 à 3,
**caractérisée en ce que** les nanoparticules de l'agent de thixotropie présente une valeur d₅₀, mesurée dans Q3, qui est supérieure ou égale à 5 nm et inférieure ou égale à 15 nm.

6. Matière de résine réactive selon au moins l'une quelconque des revendications 1 à 3,
**caractérisée en ce que** les nanoparticules de l'agent de thixotropie présentent une valeur d₅₀, mesurée dans Q3, qui est supérieure ou égale à 9 nm et inférieure ou égale à 12 nm.

7. Matière de résine réactive selon au moins l'une quelconque des revendications 1 à 6,
**caractérisée en ce qu'**elle présente au moins un matériau issu du groupe constitué de la résine époxyde, de la résine silicone et de la résine acrylique.

8. Matière de résine réactive selon au moins l'une quelconque des revendications 1 à 7,
**caractérisée en ce que** l'agent de thixotropie présente un sol colloïdal de SiO₂.

9. Matière de résine réactive selon au moins l'une quelconque des revendications 1 à 8 pour l'enrobage d'un corps émettant un rayonnement, en particulier une puce semi-conductrice, dont le spectre de rayonnement d'émission contient au moins un rayonnement issu de la région spectrale ultraviolette, bleue ou verte, qui est transparente au moins pour une partie du rayonnement émis par le corps,
**caractérisée en ce que**
la matière luminescente contient au moins des particules de matière luminescente (6) issues du groupe des grenats dopés par des terres rares, des thiogallates dopés par des terres rares, des aluminates dopés par des terres rares ou des orthosilicates dopés par des terres rares.

10. Matière de résine réactive selon au moins l'une quelconque des revendications 1 à 8, pour l'enrobage d'un corps émettant un rayonnement, en particulier une puce semi-conductrice, dont le spectre de rayonnement d'émission contient au moins un rayonnement issu de la région spectrale ultraviolette, bleue ou verte, qui est transparente au moins pour une partie du rayonnement émis par le corps,
**caractérisée en ce que**
la matière luminescente présente au moins des particules de matière luminescente (6) issues du groupe des grenats de formule générale A₃B₅O₁₂:M, le composant A contenant au moins un élément issu du groupe constitué de Y, Gd, Tb, La, Lu, Sc et Sm, le composant B contenant au moins un élément issu du groupe constitué de Al, Ga et In et le composant M contenant au moins un élément issu du groupe constitué de Ce, Pr, Eu, Cr, Nd et Er.

11. Matière de résine réactive selon l'une quelconque des revendications 1 à 10,
**caractérisée en ce que**
l'agent de thixotropie présente au moins un matériau du groupe constitué du sol colloïdal de SiO₂, du dioxyde de titane, de l'oxyde de zirconium et du SiO₂.

12. Matière de résine réactive selon l'une quelconque des revendications 1 à 11,
**caractérisée en ce que**
l'agent de thixotropie présente au moins un oxyde préparé de manière pyrogène.

13. Matière de résine réactive selon l'une quelconque des revendications 1 à 12,
**caractérisée en ce que**
l'agent de thixotropie présente des nanoparticules qui sont produites selon un procédé de chimie colloïdale, un procédé pyrogène lors d'une réaction en phase gazeuse ou selon un procédé sol-gel.

14. Matière de résine réactive selon l'une quelconque des revendications 1 à 13,
**caractérisée en ce que**
les nanoparticules présentent au moins partiellement une enduction de surface adaptée à la résine réactive.

15. Procédé de préparation d'une matière de résine réactive selon au moins l'une quelconque des revendications précédentes, **caractérisé en ce que** l'agent de thixotropie est ajouté à une résine réactive, en particulier à un composant A d'une résine époxyde, et des particules de matière luminescente sont ensuite incorporées en mélange.

16. Procédé selon la revendication 15, **caractérisé en ce que** les particules de matière luminescente sont recuites à une température ≥ 200°C.

17. Procédé selon la revendication 15 ou 16, **caractérisé en ce que** les particules de matière luminescente (6) sont munies d'une enduction de silicone.

18. Procédé selon l'une quelconque des revendications 15 à 17, **caractérisé en ce que** de la cire de silicone hydrofugeante est ajoutée aux particules de matière luminescente.

19. Procédé selon l'une quelconque des revendications 15 à 18,
**caractérisé en ce que**
les nanoparticules sont produites selon un procédé de chimie colloïdale, une réaction en phase gazeuse d'un procédé pyrogène ou selon un procédé sol-gel.

20. Procédé selon l'une quelconque des revendications 15 à 19,
**caractérisé en ce que**
les nanoparticules reçoivent un traitement de surface.

21. Composant structural optique émettant de la lumière comportant une matière de résine réactive convertissant les longueurs d'onde selon l'une des revendications 1 à 14 muni d'un corps semi-conducteur (1) émettant un rayonnement électromagnétique lors du fonctionnement du composant structural optique,
**caractérisé en ce que**
le corps semi-conducteur (1) présente une suite de couches (7) de semi-conducteur, qui convient pour l'émission d'un rayonnement électromagnétique issu de la région spectrale ultraviolette, bleue et/ou verte lors du fonctionnement du composant structural semi-conducteur,
le pigment de matière luminescente transforme une partie du rayonnement provenant de cette région spectrale en rayonnement ayant une plus grande longueur d'onde, de sorte que le composant structural semi-conducteur émet un rayonnement mixte, en particulier une lumière de couleur composée, constitué du rayonnement ayant la plus grande longueur d'onde et du rayonnement issu de la région spectrale ultraviolette, bleue et/ou verte.

22. Composant structural optique émettant de la lumière selon la revendication 21, **caractérisé en ce que** la matière de résine réactive entoure au moins une partie du corps semi-conducteur (1).

23. Composant structural semi-conducteur émettant de la lumière selon l'une quelconque des revendications 21 et 22, **caractérisé en ce que** le corps semi-conducteur (1) est agencé dans un creux (9) d'un boîtier de fond (8) non transparent à la lumière et le creux (9) est rempli au moins partiellement avec la matière de résine réactive (5).

24. Corps semi-conducteur émettant de la lumière comportant une matière de résine réactive convertissant les longueurs d'onde selon l'une quelconque des revendications 1 à 14, **caractérisé en ce qu'**il présente au moins sur une partie de sa surface une couche de conversion constituée de la matière de résine réactive et présentant de bout en bout sensiblement la même épaisseur.
